# DEMANDE DE BREVET EUROPEEN

(11) **EP 1 770 769 A1**
(43) Date de publication de la demande: **04.04.2007**
(21) Numéro de dépôt: 06121019.1
(22) Date de dépôt: 21.09.2006
(51) Int. Cl.: H01L 21/336, H01L 29/786

(54) **Transistor MOS vertical et procédé de fabrication**

(30) Priorité: 30.09.2005 FR 0510022
(71) Demandeur: Commissariat à l'Energie Atomique, 75015 Paris (FR)
(72) Inventeur: Previtali, Bernard, 38100, GRENOBLE (FR)
(74) Mandataire: Guérin, Michel

(57) **Abrégé**

L'invention concerne un transistor à effet de champ vertical. Il comporte un îlot de matériau semiconducteur monocristallin dopé (12) comprenant une région de drain (15) et une région de contact de drain (17) disposée latéralement par rapport à la région de drain, et, au-dessus de l'îlot, une région de source (38) et plusieurs canaux parallèles verticaux (36) en matériau semiconducteur monocristallin peu dopé, s'étendant verticalement entre la région de drain et la région de source, chaque canal étant complètement entouré par une gaine isolante (46), et l'espace qui sépare les canaux ainsi isolés les uns des autres étant comblé par une grille conductrice (50) enrobant chacun des canaux. L'invention porte également sur un procédé de fabrication original utilisant une couche de grille sacrificielle dont l'épaisseur définit la longieur des canaux.

## Description

L'invention concerne les transistors à effet de champ à grille isolée (transistors MOS), et plus particulièrement les transistors dits "verticaux", dont la particularité est qu'ils comportent une région de drain et une région de source situées l'une au dessus de l'autre, avec un canal semiconducteur très court constitué par l'épaisseur d'une couche semiconductrice entre la source et le drain. Le canal est associé à une grille de commande qui permet d'autoriser ou d'interdire le passage de courant entre la source et le drain.

Le transistor vertical présente l'avantage d'une très courte longueur de canal puisque cette longueur peut être définie par l'épaisseur (très bien maîtrisée et pouvant être très petite) d'une couche semiconductrice, alors que dans les transistors "horizontaux", la longueur de canal ne peut être définie que par un masquage photolithographique. Le masquage photolithographique présente une limite de résolution intrinsèque liée à la longueur d'onde utilisée. En photolithographie optique on ne peut guère descendre au-dessous de quelques dixièmes de micromètres, alors qu'il serait intéressant de descendre à quelques dizaines de nanomètres, voire même moins. Une courte longueur de canal permet une très grande rapidité de fonctionnement du transistor, ce qui est de plus en plus recherché dans de nombreuses applications.

De plus, le transistor vertical peut être globalement plus compact q'un transistor horizontal car la source est située au-dessus ou au-dessous du drain et non à côté du drain.

L'article "Selectively grown vertical Si MOS transistor with reduced overlap capacitances", de D. Klaes et autres, dans la revue Thin Solid Films 336 (1998) pages 306-308, la demande de brevet FR A1-2 810 792, et le brevet US 6 518 622 décrivent des transistors verticaux. Cependant, ces transistors ne sont pas optimisés du point de vue
- de l'encombrement,
- de la capacité de transmettre suffisamment de courant à travers le canal tout en contrôlant bien ce courant par la grille,
- et des capacités parasites qui existent entre grille et drain ou grille et source et qui limitent la vitesse de fonctionnement du transistor.

Un paramètre important des performances des transistors est en particulier le rapport entre le courant dans l'état passant et le courant de fuite dans l'état bloqué. Ce rapport devrait être de préférence au moins égal à 1000, mais il tend à se dégrader lorsqu'on réduit la longueur de grille.

D'autres problèmes peuvent être rencontrés, tels que la difficulté de réaliser et contrôler le contact avec la grille de commande du transistor, ou la qualité de la résistance d'accès à la source ou au drain du transistor.

Pour optimiser les performances des transistors à effet de champ verticaux, la présente invention propose une nouvelle structure de transistor vertical, et un nouveau procédé de fabrication.

Le procédé de fabrication selon l'invention comporte les étapes suivantes :
- a) délimitation d'un îlot de matériau semi-conducteur (silicium ou germanium notamment ou alliage silicium-germanium) formant une région de drain latéralement adjacente à une région de contact de drain ;
- b) dépôt d'au moins une couche dite couche de grille sacrificielle, dont l'épaisseur définit la longueur des canaux séparant la région de drain d'une région de source située au dessus de la région de drain,
- c) perçage de trous verticaux dans la couche de grille sacrificielle, au dessus de la région de drain et jusqu'à la surface de matériau semi-conducteur de cette région,
- d) croissance épitaxiale de matériau semi-conducteur peu dopé dans les trous à partir du matériau semi-conducteur de la région de drain, pour former à la fois des canaux semiconducteurs monocristallins verticaux et la région de source du transistor,
- e) dopage de la région de source,
- f) enlèvement de la couche de grille sacrificielle, laissant subsister les canaux en matériau semi-conducteur entre la région de source et la région de drain, dans une cavité entourant ces canaux, et formation d'une gaine isolante autour de chaque canal,
- g) remplissage de la cavité par un matériau conducteur formant grille définitive isolée des canaux par les gaines isolantes,
- h) formation d'interconnexions en contact avec la région de contact de drain, avec la région de source, et avec la grille définitive.

De préférence, l'étape b comporte le dépôt d'une couche isolante (de préférence du nitrure de silicium, mais éventuellement aussi de l'oxyde, de silicium, du nitrure de germanium) avant le dépôt de la couche de grille sacrificielle, et le dépôt d'une autre couche isolante (nitrure de silicium) après le dépôt de la couche de grille sacrificielle. Ces couches servent de barrière lors d'étapes de gravure sélective ultérieures.

La couche de grille sacrificielle est gravée à l'étape b de préférence de manière à recouvrir la région de drain et une région de contact de grille extérieure à l'îlot de matériau semi-conducteur, mais sans recouvrir la région de contact de drain.

Pour faciliter la gravure ultérieure des interconnexions métalliques, on peut prévoir une étape de dépôt de couche isolante de planarisation après la gravure de la couche de grille sacrificielle, avant l'étape c.

Le perçage des canaux parallèles étroits dans toute l'épaisseur de la couche de grille sacrificielle, est fait de préférence en utilisant une lithographie par faisceau d'électrons.

Deux grandes variantes du procédé selon l'invention peuvent être envisagées : dans une première variante, le matériau de la couche de grille sacrificielle est du silicium amorphe ou polycristallin ou un matériau oxydable similaire tel qu'un composé de silicium et de germanium ; dans une deuxième variante, le matériau de la couche de grille sacrificielle est de l'oxyde de silicium.

A l'étape f, la formation d'une gaine isolante autour de chaque canal est faite de préférence après l'enlèvement de la couche de grille sacrificielle.

On peut noter qu'il est possible de former sur un même îlot de silicium deux transistors de type opposé, NMOS et PMOS, ayant une région de drain commune, une grille commune, et des sources distinctes, réalisant ainsi un inverseur à transistors complémentaires.

Outre le procédé de fabrication original indiqué ci-dessus, la présente invention concerne également une nouvelle structure de transistor à effet de champ vertical : ce transistor est caractérisé en ce qu'il comporte un îlot de matériau semiconducteur monocristallin dopé comprenant une région de drain et une région de contact de drain disposée latéralement par rapport à la région de drain, et, au-dessus de l'îlot, une région de source et plusieurs canaux parallèles verticaux en matériau semiconducteur monocristallin peu dopé, s'étendant verticalement entre la région de drain et la région de source, chaque canal étant complètement entouré par une gaine isolante, l'espace qui sépare les canaux ainsi isolés les uns des autres étant comblé par une grille conductrice enrobant chacun des canaux.

La grille s'étend de préférence au-dessus de la région de drain mais pas au-dessus de la région de contact de drain.

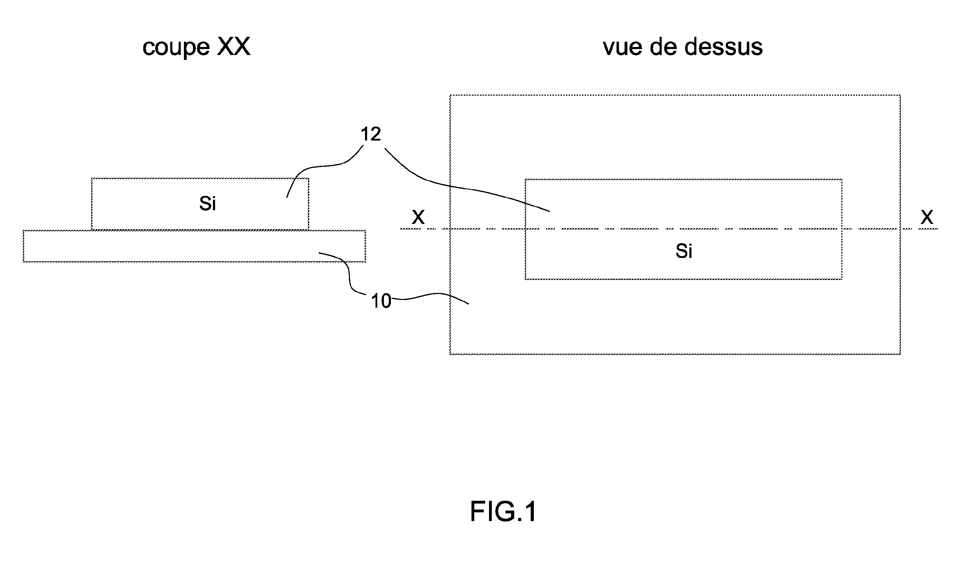

D'autres caractéristiques et avantages de l'invention apparaîtront à la lecture de la description détaillée qui suit et qui est faite en référence aux dessins annexés dans lesquels les figures 1 à 21 représentent les étapes successives détaillées d'une mise en oeuvre préférée du procédé de fabrication selon l'invention.

De manière générale, dans la description qui suit, chaque figure comporte pour la clarté des explications, à la fois une vue de dessus et une ou deux vues en coupe selon un ou deux axes XX (horizontal sur la figure) et/ou YY (vertical sur la figure) définis sur la vue de dessus. Les dessins ne sont pas à l'échelle, pour faciliter la lisibilité des schémas.

On part d'un substrat 10 dans lequel on délimite une zone active semiconductrice (en silicium dans le cas général) correspondant au transistor à réaliser.

Dans l'exemple représenté, on suppose que le substrat de départ est un substrat de type SOI ("Silicon on Insulator" en anglais, c'est-à-dire Silicium sur Isolant) sur lequel est formé un îlot de silicium monocristallin 12. On pourrait aussi partir d'un substrat de silicium, définir une zone périphérique isolante par procédé Locos (isolation localisée par oxydation thermique du silicium), cette zone entourant une région de silicium dans laquelle sera formée le transistor. On pourrait aussi faire une délimitation de l'îlot par une tranchée périphérique isolante dans un substrat de silicium.

L'îlot pourrait aussi être en germanium ou en alliage germanium-silicium.

Cette première étape (figure 1) sert seulement à définir la région semiconductrice dans laquelle sera formé le transistor.

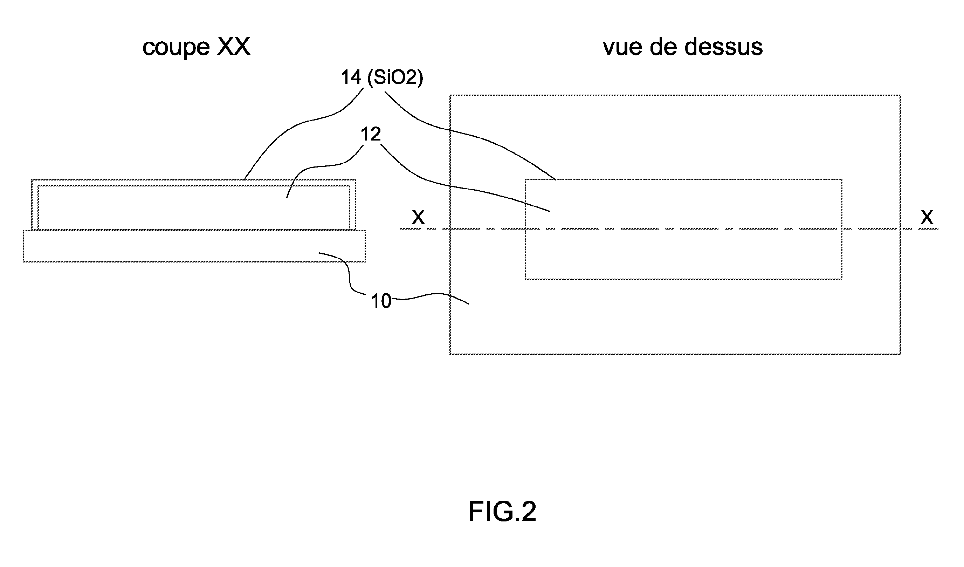

On dépose (figure 2) une fine couche isolante 14, de préférence de l'oxyde de silicium, qui recouvre la totalité de l'îlot de silicium, flancs latéraux compris. L'oxyde peut être déposé ou formé par oxydation thermique du silicium.

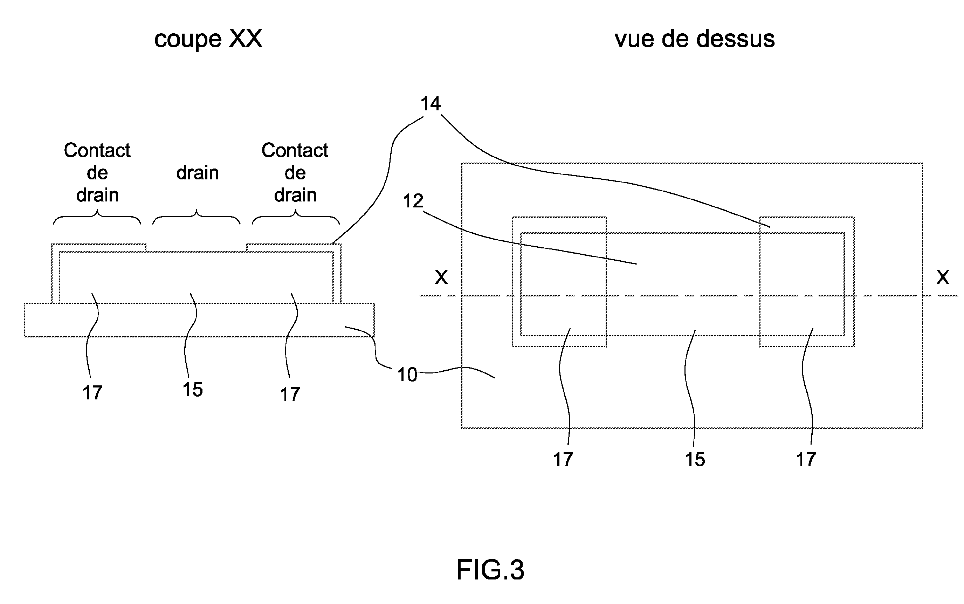

On masque alors une partie de l'îlot 12 (dans cet exemple : les deux extrémités mais cela pourrait être une seule extrémité, spécialement si on veut réduire l'encombrement), et on enlève l'oxyde dans la région non masquée (figure 3). La région de silicium ainsi mise à nu correspond à une région de drain 15 du transistor vertical : la grille sera au-dessus du drain, la source sera au-dessus de la grille. Dans ce qui suit on appelera drain la région qui est en bas et source la région qui est en haut, étant entendu que ces appellations sont interchangeables puisqu'elles sont liées à l'utilisation du transistor et non à sa constitution.

Les contacts de drain seront pris ultérieurement sur la partie 17 qui reste actuellement protégée par l'oxyde de silicium 14 ; cette partie 17 est adjacente latéralement à la région de drain 15 et sera appelée ci-après "région de contact de drain". On verra ultérieurement que la région de contact de drain sera de préférence siliciurée (ou germanurée) pour améliorer sa conductivité électrique et réduire les résistances d'accès du contact avec le drain.

On a représenté sur les figures un masquage de deux extrémités d'une bande de silicium rectangulaire ; on pourrait ne masquer qu'une extrémité, ou inversement masquer toute une périphérie de l'îlot s'il avait une forme carrée ou circulaire.

Le silicium de l'îlot peut être dopé à différents stades pour être de type N dans le cas d'un transistor NMOS ou P dans le cas d'un transistor PMOS. Si au stade de la figure 3 le silicium n'est pas déjà suffisamment dopé, on procède à un dopage, de préférence par implantation ionique. L'implantation est de type N (arsenic, antimoine, phosphore, ...) ou P (bore) selon le type de transistor à réaliser. L'implantation se fait à la fois dans la région de drain 15 non protégée par l'oxyde 14 et dans les régions de contact de drain 17 protégées par l'oxyde, l'implantation étant faite à une énergie suffisante pour passer à travers l'oxyde.

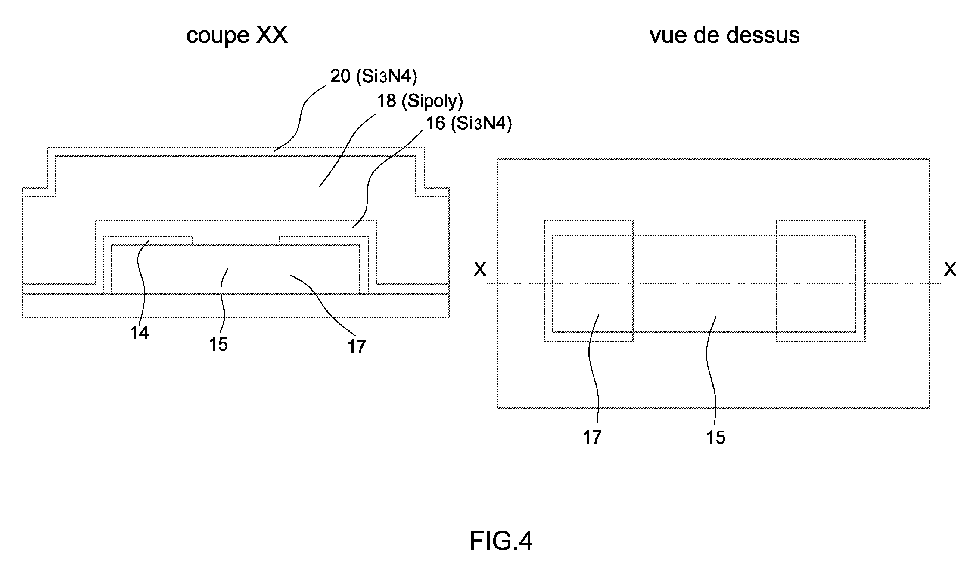

On dépose ensuite uniformément (figure 4) une couche isolante 16 en nitrure de silicium, puis une couche de silicium amorphe ou polycristallin 18, puis une nouvelle couche isolante en nitrure de silicium 20. La couche de nitrure 16 est très mince, de préférence inférieure à 5 nanomètres. La couche 20 également.

La couche de nitrure 16 est une couche barrière, empêchant ultérieurement l'attaque du silicium 12 dans la région de drain lors d'une gravure de la couche 18. La couche 16 est une couche isolante qui a un rôle d'espaceur parce qu'elle éloigne la région de drain des régions de canaux (elle limite les effets de canaux courts). Avantageusement, elle sera choisie de façon à servir de couche d'arrêt dans des gravures ultérieures. Elle empêche aussi la diffusion d'oxygène dans la couche 15.

La couche de nitrure 20 sert de couche de protection de la couche 18 en silicium polycristallin pendant la gravure de ce dernier.

La couche de silicium amorphe ou polycristallin 18 est une couche sacrificielle appelée ci-après "couche de grille sacrificielle" : elle est là provisoirement et sera éliminée ultérieurement. Son épaisseur définit la longueur des canaux verticaux semiconducteurs qui sépareront le drain de la source du transistor vertical. Cette épaisseur peut être de quelques dizaines de nanomètres. On verra que dans une autre réalisation cette couche peut être en oxyde de silicium, ce qui peut simplifie la fabrication. Dans ce qui suit on considérera qu'il s'agit de silicium polycristallin, l'adjectif polycristallin étant considéré ici comme synonyme de "amorphe", ces deux termes étant considérés par opposition à "monocristallin". Un alliage silicium-germanium peut également être utilisé, l'avantage de ce dernier matériau étant sa très bonne sélectivité de gravure par rapport à l'oxyde et au nitrure de silicium.

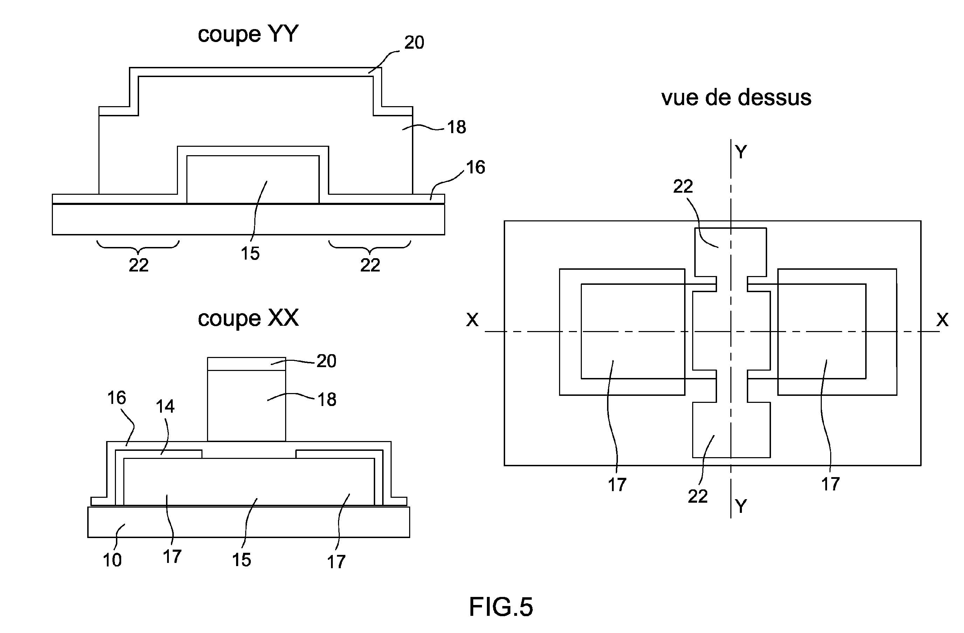

On grave ensuite (figure 5) la couche de nitrure 20, à l'aide d'un masque de résine de photolithographie, puis la couche de silicium 18 à l'aide du masque de nitrure 20 qui subsiste, pour les enlever au dessus des régions de contact de drain 17 (celles qui sont recouvertes d'oxyde 14) comme on le voit bien sur la coupe XX de la figure 5. L'attaque du silicium est sélective et s'arrête sur la couche de nitrure 16. On laisse subsister les couches 18 et 20 non seulement au dessus de la région de drain 15 proprement dite mais aussi sur le substrat 10 dans une région 22 qui n'est pas située au dessus de l'îlot de silicium 12, c'est-à-dire une région 22 qui n'est ni au-dessus de la région de drain 15 ni au dessus de la région de contact de drain 17, comme on le voit bien sur la vue de dessus et la coupe YY de la figure 5. Cette région de grille 22 sur le substrat 10 servira ultérieurement à la prise d'un contact de grille comme on le verra. Sur la figure 5, en vue de dessus, on voit deux régions de contact de grille 22, une de chaque côté de la région de drain centrale 15, qui constituent des extensions latérales de la grille en dehors des régions de drain (15) et de contact de drain (17). La présence de deux régions de contact de grille facilite l'enlèvement ultérieur de la couche de grille sacrificielle.

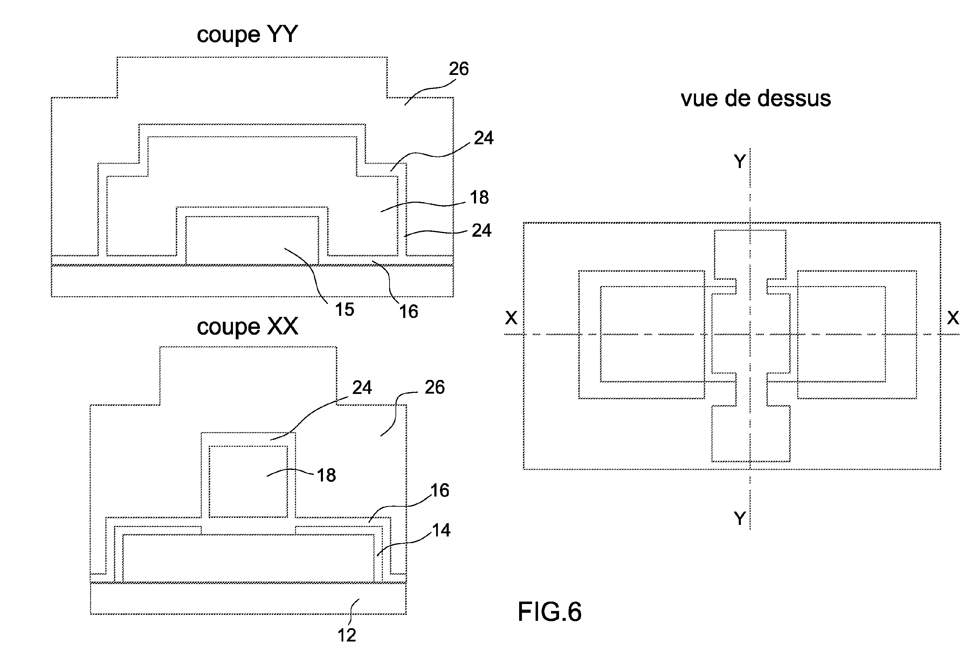

L'étape suivante (figure 6) consiste à recouvrir à nouveau l'ensemble du transistor d'une couche de nitrure de silicium 24 (qui servira de couche d'arrêt d'attaque) qui recouvre les parties dénudées de la couche de silicium 18, à savoir les flancs latéraux de cette couche. La couche de nitrure 24 constituera une couche d'arrêt de gravure lors d'opérations ultérieures. Puis, on dépose une couche d'oxyde de silicium 26. La couche d'oxyde 26 est suffisamment épaisse pour combler en partie les creux du relief créé par les couches inférieures, de sorte qu'on puisse ensuite, par enlèvement de l'excédent d'oxyde, aplanir le relief présent sur le substrat.

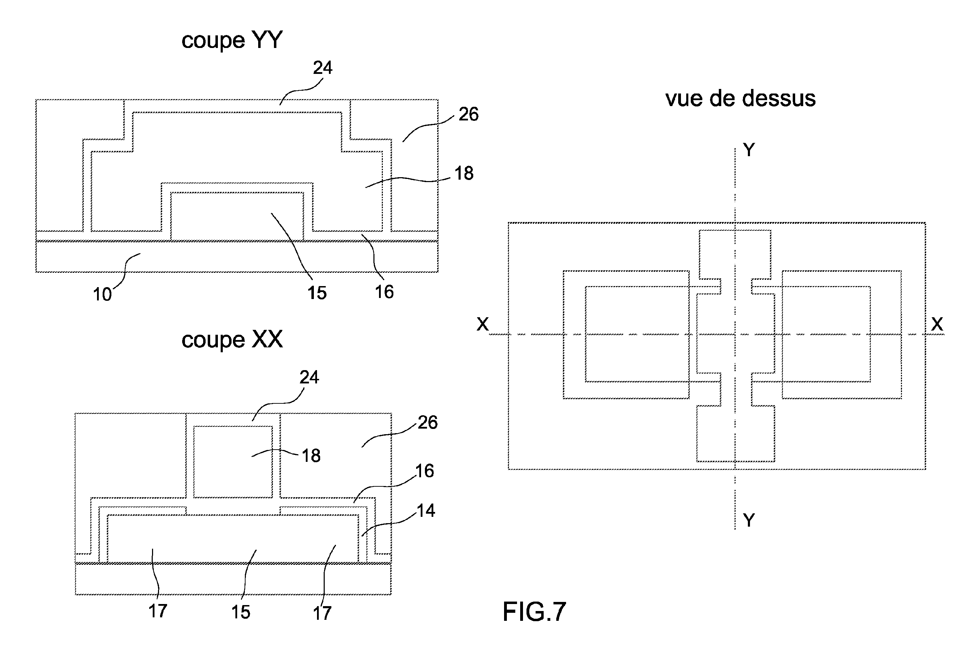

Une étape de planarisation (figure 7) est donc effectuée ; elle comprend une attaque physico-chimique de l'oxyde 26 jusqu'à mettre à nu le nitrure de silicium 24 au-dessus de la région de drain 15 sans enlever l'oxyde dans les creux du relief et notamment sans enlever l'oxyde 26 au dessus des régions de contact de drain 17.

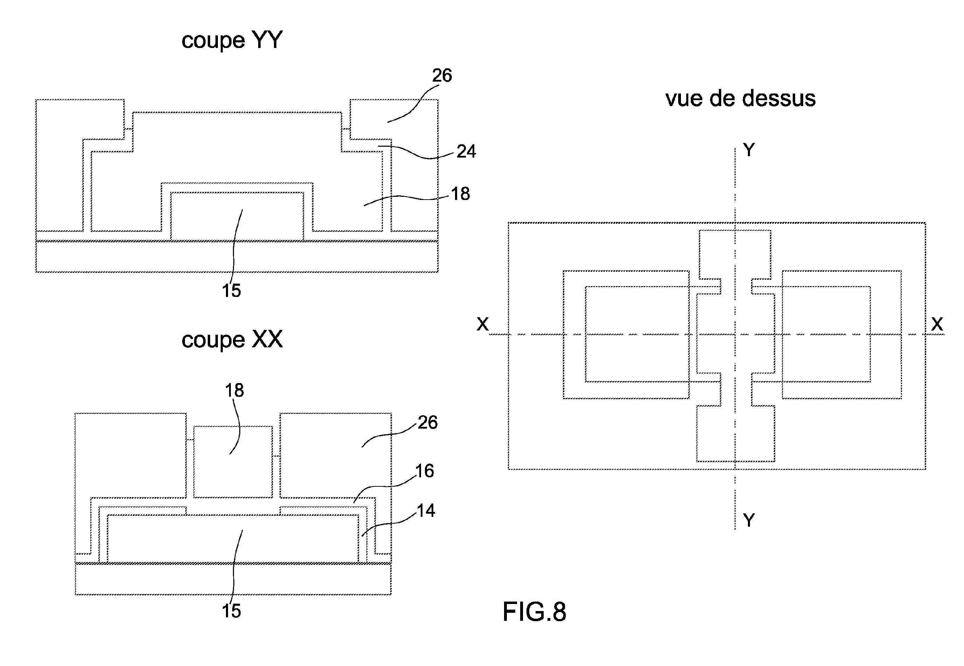

On peut alors enlever (figure 8) le nitrure résiduel de la couche 24 là où il n'est pas protégé par le reste de la couche d'oxyde 26, mettant à nu la couche de grille sacrificielle 18 uniquement au-dessus de la région de drain 15.

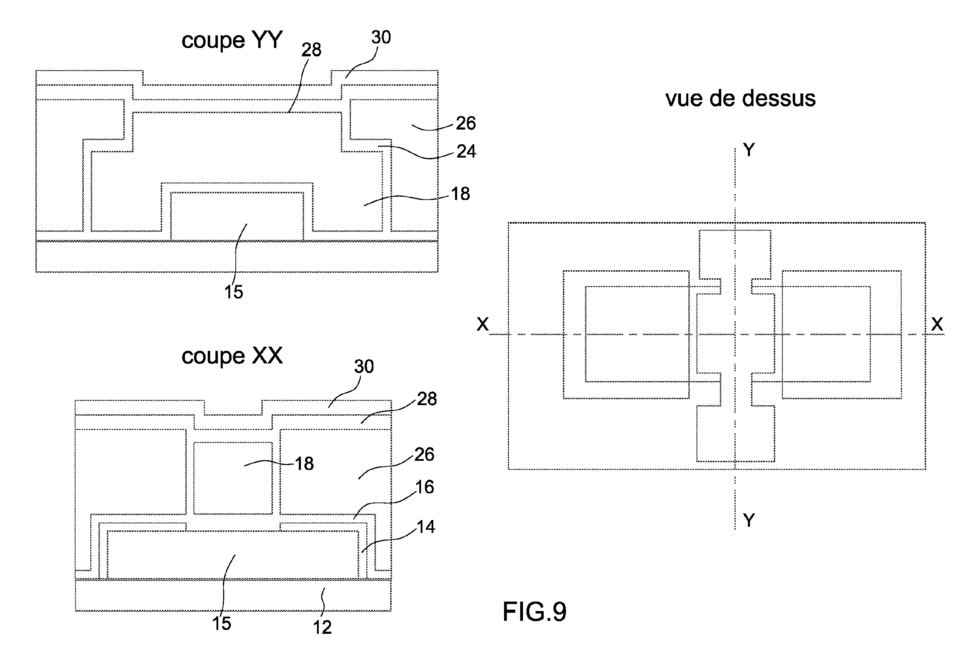

On dépose à nouveau uniformément (figure 9) une couche de nitrure de silicium 28 très mince suivie d'une couche d'oxyde de silicium 30. La couche de nitrure 28 a de préférence à peu près la même épaisseur que la couche de nitrure 16 : inférieure à 5 nanomètres si possible. La couche d'oxyde 30 servira à protéger le nitrure 28 lorsqu'il faudra ultérieurement attaquer le nitrure de la couche 16 au-dessus de la région de drain.

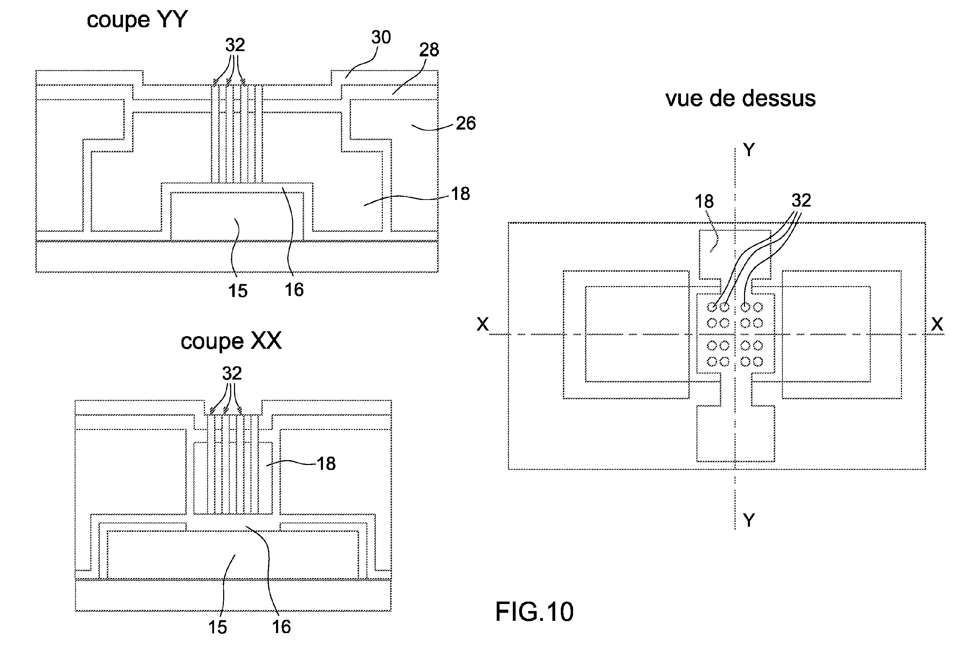

On effectue alors (figure 10) l'étape essentielle de gravure de trous verticaux à travers la couche de grille sacrificielle 18. Il s'agit d'une série de trous parallèles verticaux 32 de faible diamètre. Le nombre de trous est lié au courant que l'on veut faire passer dans le transistor, une fraction de courant passant dans chaque trou après que ces trous aient été remplis de matériau semiconducteur constituant les canaux du transistor. La gravure des trous verticaux se fait de préférence par un faisceau électronique à travers un masque de résine photogravée. On grave d'abord la couche d'oxyde 30 puis la couche de nitrure 28 puis la couche de silicium polycristallin 18, et on arrête la gravure sur la fine couche de nitrure 16 qui protège la région de drain.

On obtient alors une couche de grille sacrificielle 18 percée de trous verticaux à l'aplomb de la région de drain, comme on le voit sur la figure 10. Les trous peuvent avoir un diamètre d'environ 40 nanomètres. Les canaux semiconducteurs qui seront formés dans ces trous auront un diamètre encore inférieur à cette valeur. La subdivision du canal du transistor en plusieurs canaux individuels qui seront chacun entouré par une gaine isolante et une grille de commande permet d'améliorer le rapport entre le courant du transistor passant et le courant du transistor bloqué.

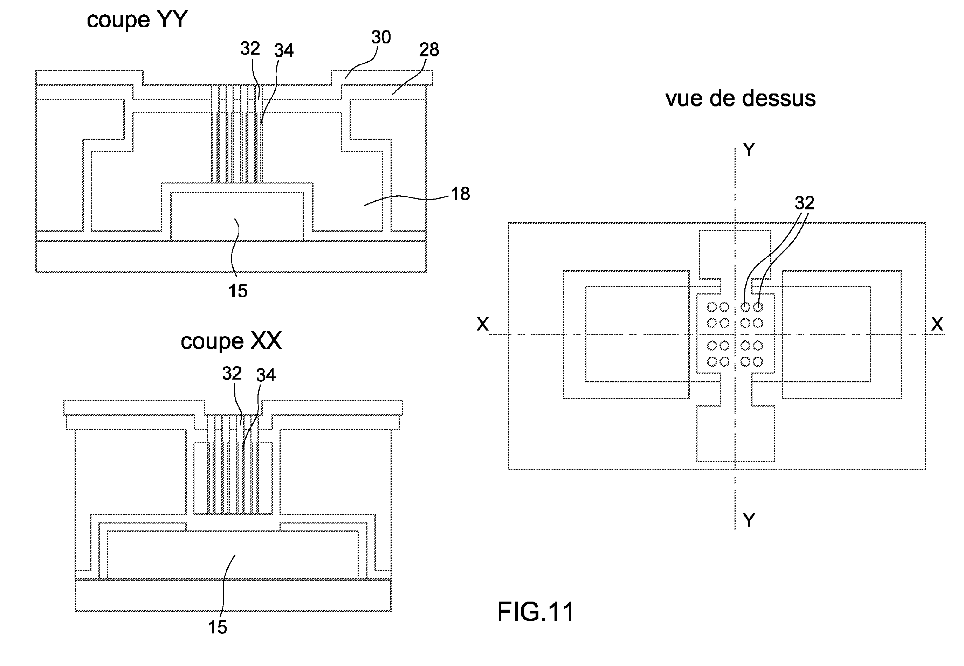

L'étape suivante (figure 11) consiste à oxyder superficiellement la paroi interne des trous. L'oxydation est une oxydation thermique du silicium polycristallin 18, qui permet de réduire le diamètre des trous 32. On obtient des trous dont les parois internes sont couvertes d'une gaine isolante 34 constituée d'oxyde de silicium. On peut conserver cette gaine isolante soit définitivement soit temporairement. Dans l'exemple présent on la conserve temporairement avant d'en former une autre. En effet, la gaine isolante 34 à ce stade a une épaisseur relativement importante et il est préférable de la remplacer ultérieurement par une épaisseur d'isolant de grille moindre qui permet une meilleure commande du transistor. Typiquement, si on souhaite réduire le diamètre des canaux à environ 10 nanomètres, il faut faire croître une couche d'oxyde de plusieurs dizaines de nanomètres ; une telle épaisseur est trop élevée pour servir d'isolant de grille autour de chaque canal.

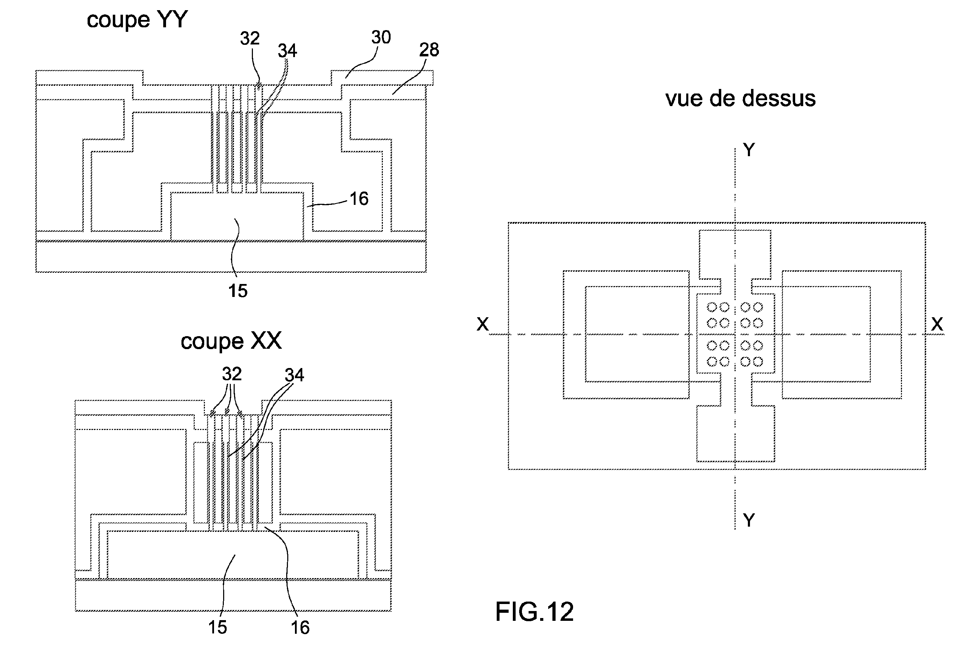

On attaque alors chimiquement (figure 12) la couche de nitrure 16 qui est dénudée au fond des trous 32. Cette attaque met à nu le silicium du drain au fond des trous. On peut, à ce stade, doper ou redoper la région de drain à travers les trous, par une impureté correspondant au type de transistor à réaliser, si les dopages précédents qui ont pu avoir lieu ne sont pas suffisants.

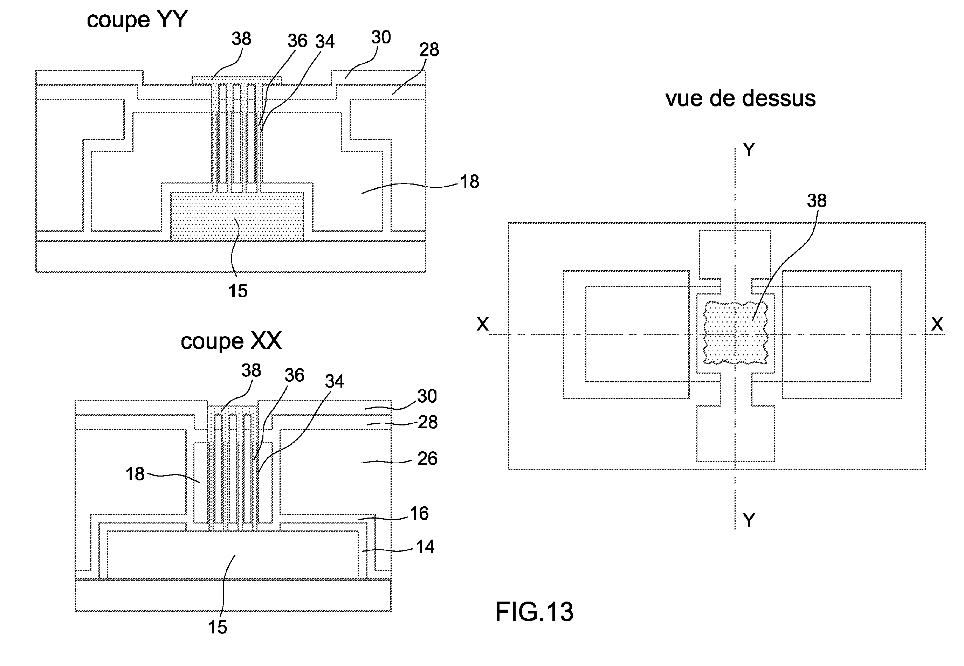

On fait ensuite croître (figure 13), par épitaxie, du silicium à l'intérieur des trous : le silicium déposé par décomposition en phase gazeuse d'un précurseur du silicium (du silane en général) croît de manière épitaxiale à partir de germes monocristallins qui sont constitués par la couche de silicium 12 mise à nu dans le fond des trous. Les trous se remplissent de silicium peu dopé (en pratique du silicium intrinsèque ou quasi-intrinsèque) constituant les canaux semiconducteurs 36 du transistor MOS. Les canaux 36 sont recouverts d'isolant (oxyde 34) sur toute leur hauteur. En faisant croître l'épitaxie suffisamment longtemps, on réalise de plus à la partie supérieure une couche continue 38 qui va servir de région de source lorsqu'elle sera dopée. Les canaux semiconducteurs 36 touchent donc le drain 15 en bas et touchent la région de source 38 en haut.

On procède à ce stade au dopage de la source, de même type que le drain (mais pas forcément à la même dose), par implantation ionique dans l'épaisseur de la couche 38, sans pénétration profonde dans les canaux 36.

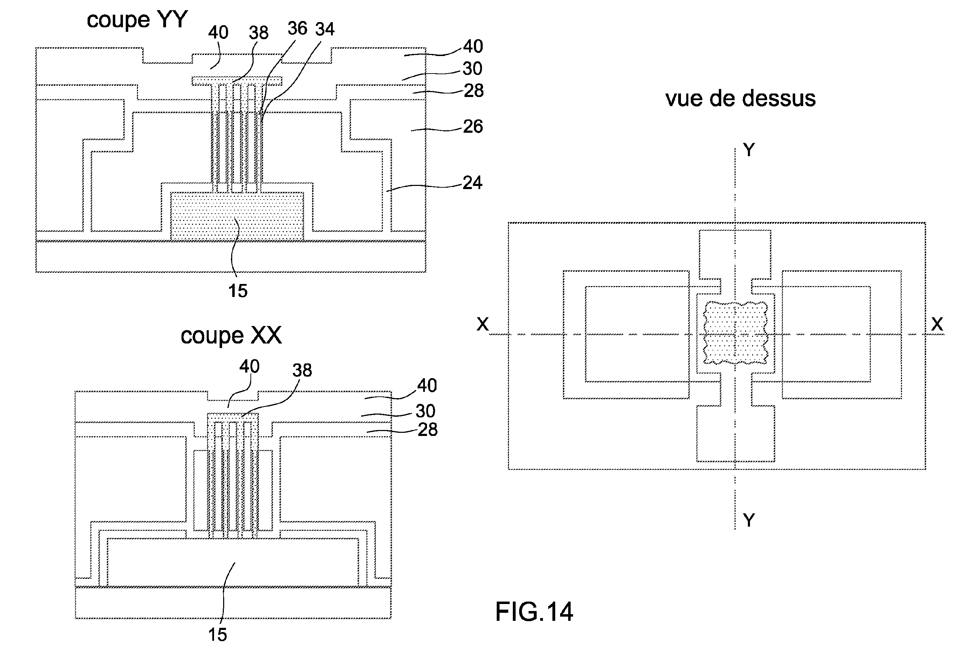

La source étant ainsi réalisée, on protège sa surface par une couche d'oxyde 40 qui se superpose à la couche 30 déjà présente sur l'ensemble du substrat (figure 14).

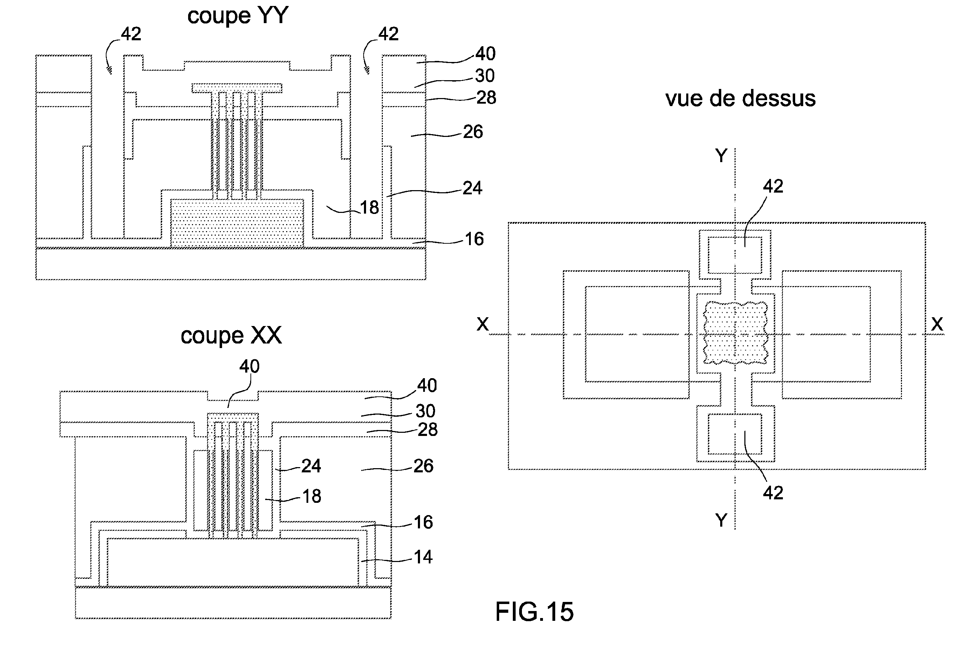

Les opérations suivantes servent à éliminer complètement la couche de grille sacrificielle pour la remplacer par une grille définitive. Ces opérations comprennent une étape de photolithographie standard (dépôt de résine, masquage, insolation et développement) servant à ouvrir des trous d'accès 42 au-dessus de la grille sacrificielle, dans l'empilement de couches 40, 30, 28, 26, 24, 18. Ces trous 42 sont localisés en dehors de l'îlot de silicium 12, et plus précisément dans les régions 22 de contact de grille. Les trous 42 vont en profondeur jusqu'à la couche de nitrure de silicium 16 qui constitue une couche d'arrêt de gravure dans cette opération de creusement des trous (figure 15). Dans ces opérations, chaque couche gravée sert de masque de gravure pour la couche suivante et les produits d'attaque sont anisotropes et sélectifs de manière à attaquer une couche verticalement et non latéralement et de manière à ne pas attaquer la couche immédiatement sous-jacente.

Les trous 42 serviront de passage pour évacuer le matériau de la grille sacrificielle 18 et ultérieurement pour le remplacer par un autre matériau définitif. Il est préférable d'avoir deux trous 42, respectivement un de chaque côté de l'îlot de silicium 12, pour faciliter l'extraction par ces trous de la matière qui compose la couche sacrificielle.

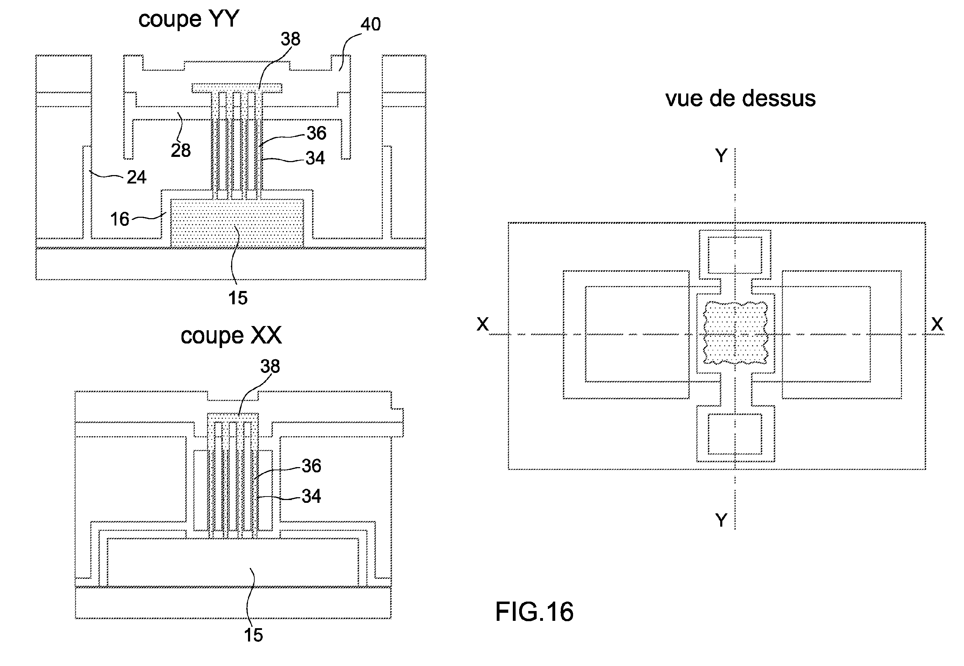

Pour enlever la couche de grille sacrificielle 18, on effectue (figure 16) une attaque isotrope du silicium polycristallin par un produit d'attaque qui pénètre par les trous d'accès 42. Le produit d'attaque choisi est sélectif et ne détériore ni le nitrure de silicium de la couche 16 ni l'oxyde de silicium 34 qui entoure chaque canal 36. L'enlèvement de la couche sacrificielle laisse libre une cavité surplombant la région de drain 15 et s'étendant de part et d'autre de celle-ci dans les régions 22. Les canaux 36, enveloppés de leur gaine d'oxyde de silicium 34 qui les protège, restent en place entre la source 38 et le drain 15 sous forme de piliers qui traversent la cavité dans le sens vertical. L'espacement des canaux et le diamètre des canaux revêtus de leur gaine isolante est tel qu'un espace libre subsiste en pratique entre les canaux isolés adjacents.

A ce stade, on considère que la gaine isolante 34 est trop épaisse (plusieurs dizaines de micromètres en pratique) pour pouvoir servir d'isolant de grille dans la structure finale du transistor, et on va donc éliminer cette gaine pour la remplacer par une autre gaine isolante plus mince (quelques nanomètres au maximum, par exemple environ 1 nanomètre). Pour cela on procède à une désoxydation qui enlève l'oxyde 34.

On peut, si on le souhaite, procéder à une nouvelle réduction de l'épaisseur des canaux de silicium 36 : dans ce cas, on oxyde thermiquement le silicium des canaux puis on enlève l'oxyde formé ; cet oxyde ayant consommé une partie de l'épaisseur de silicium des canaux, l'épaisseur finale de ceux-ci est réduite.

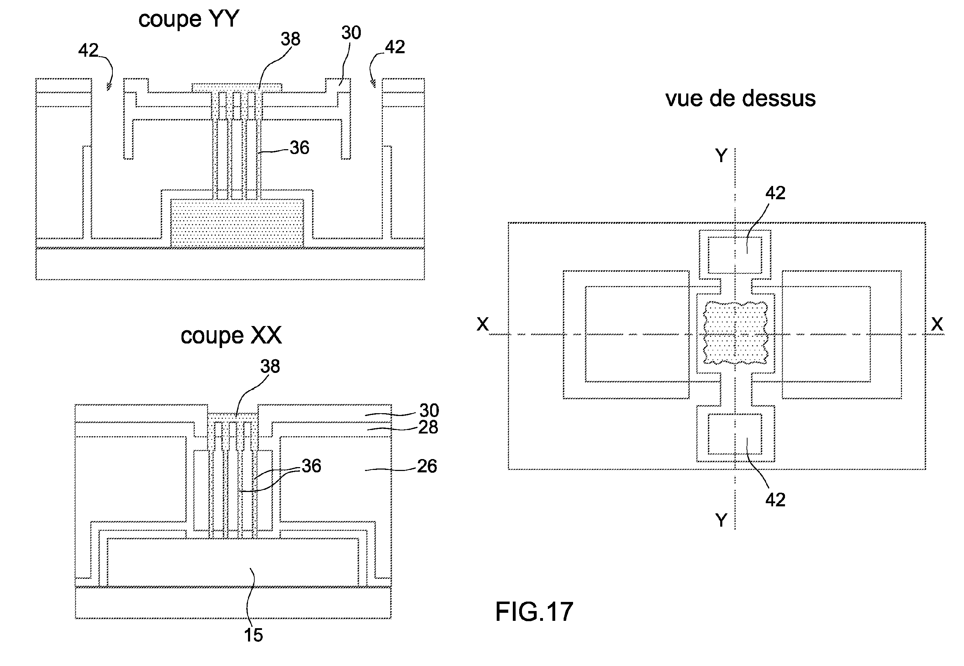

On enlève également (figure 17) l'épaisseur d'oxyde de silicium 40 qui avait été rajoutée pour protéger la source avant les opérations d'élimination de la grille sacrificielle. La source 38 est à nouveau mise à nu ; cependant on n'enlève pas la totalité de l'épaisseur d'oxyde présente sur le transistor, de sorte que l'oxyde de silicium de la couche 30 subsiste en dehors de la source 38. Une implantation d'impuretés dans la source est encore possible à ce stade si nécessaire.

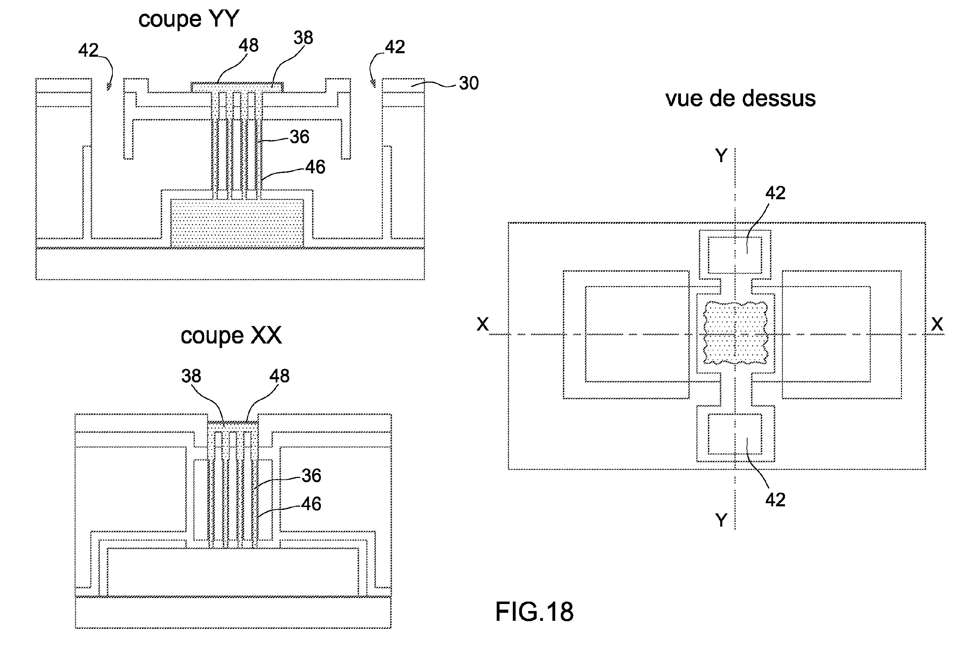

On dépose alors (figure 18) une fine couche d'oxyde de silicium isolant qui vient recouvrir toutes les parties accessibles, y compris à l'intérieur de la cavité laissée vide par l'élimination de la grille sacrificielle. L'isolant vient recouvrir individuellement chacun des canaux 36 et constitue alors la gaine isolante 46 définitive de chacun des canaux 36. Un espace reste libre entre les différents canaux gainés d'isolant et cet espace sera comblé ultérieurement par un matériau conducteur constituant la grille du transistor de sorte que la conduction de courant dans chaque canal sera parfaitement contrôlée par la grille à travers une très fine épaisseur d'isolant de grille 46.

Le dépôt d'isolant constituant la gaine isolante 46 provoque également le dépôt d'une fine couche isolante 48 sur la source 38 et protégera celle-ci ultérieurement lors de la gravure de la grille définitive.

On notera que l'isolant 46 ou 48 pourrait être formé par oxydation thermique du silicium plutôt que par dépôt d'oxyde.

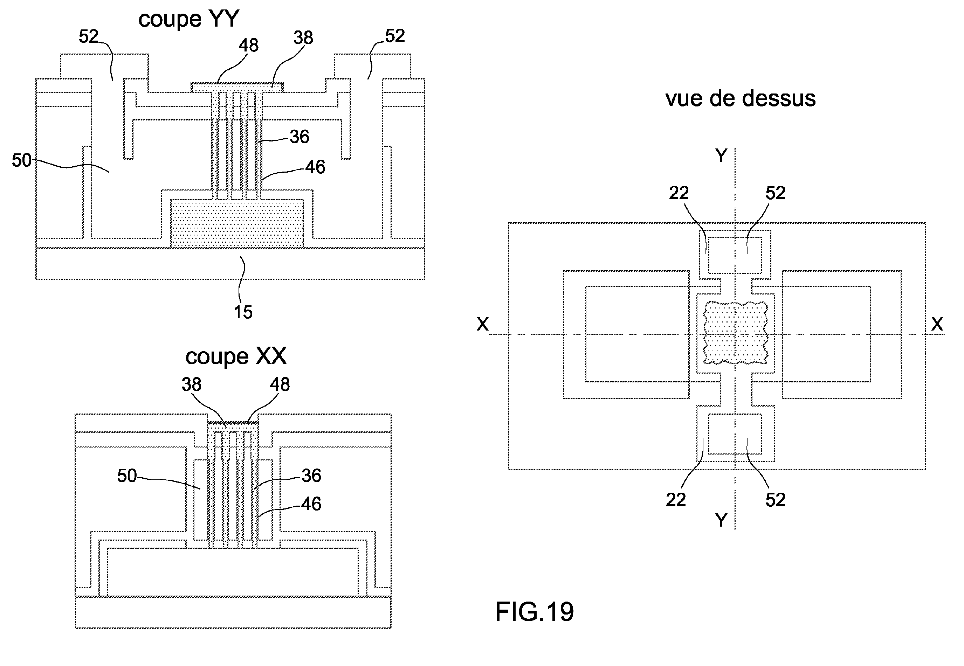

Ensuite (figure 19) on effectue un dépôt d'un matériau de grille définitive 50 qui vient combler toute cette cavité en passant par les trous 42 par lesquels on a évacué la grille sacrificielle. Ce matériau peut être notamment du silicium polycristallin dopé, ou du nitrure de titane ; puis, une étape de photolithographie exécutée sur le matériau de grille 50 permet de définir les contacts de grille 52 à l'extérieur de la cavité, en éliminant en grande partie le matériau de grille qui recouvre alors l'ensemble du substrat. Les contacts de grille sont situés au-dessus des régions 22 définies en référence à la figure 5. La source 38 reste protégée par l'oxyde 48 pendant cet enlèvement du matériau de grille.

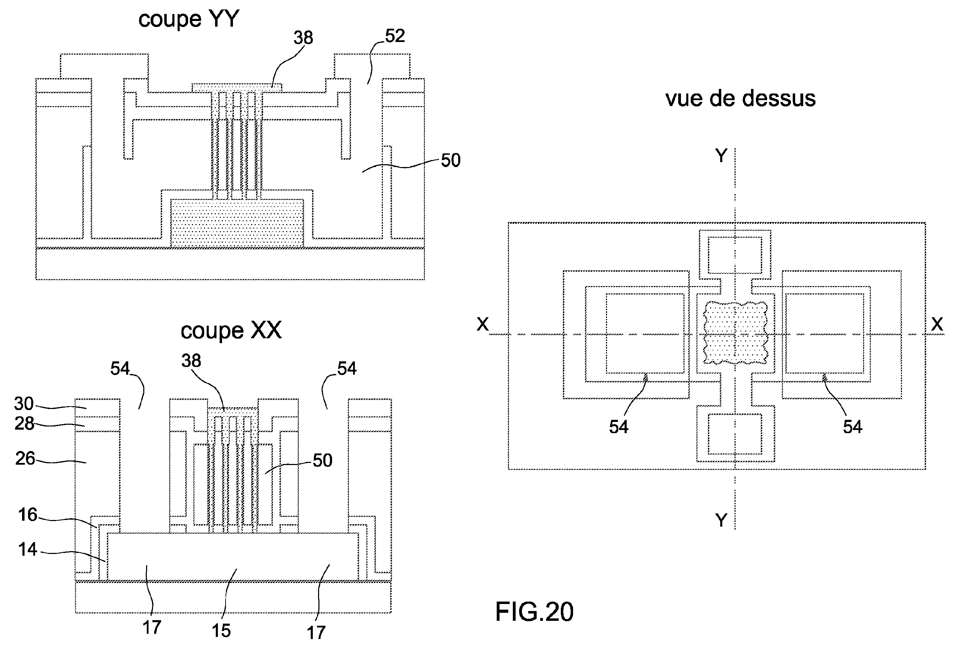

L'étape suivante (figure 20) comprend de préférence les opérations suivantes : photolithographie pour définir des ouvertures 54 d'accès aux régions 17 de contact de drain, de part et d'autre de la région de drain 15. Ces ouvertures 54 sont creusées par gravure anisotrope verticale successivement dans les couches 30 (oxyde), 28 (nitrure), 26 (oxyde), 16 (nitrure) et 14 (oxyde). Elles mettent à nu le silicium de l'îlot en vue d'une prise de contact de drain dans les régions 17.

Une implantation de drain est encore possible à ce stade. Si c'est nécessaire, une dernière opération de désoxydation enlève l'oxyde de silicium présent sur les régions de contact de drain à l'intérieur des ouvertures 50 et sur la source 38.

On peut alors déposer une couche métallique (titane, tantale, tungstène, etc.) et effectuer un recuit qui réalise un alliage (siliciure métallique) entre le silicium et ce métal sur la source 38, sur les régions de contact de drain 17 dans les ouvertures 54, et également sur les contacts de grille 52 qui affleurent en surface. Le métal non allié peut être enlevé en dehors des zones de siliciuration à l'aide d'un produit sélectif qui attaque le métal sans attaquer le siliciure.

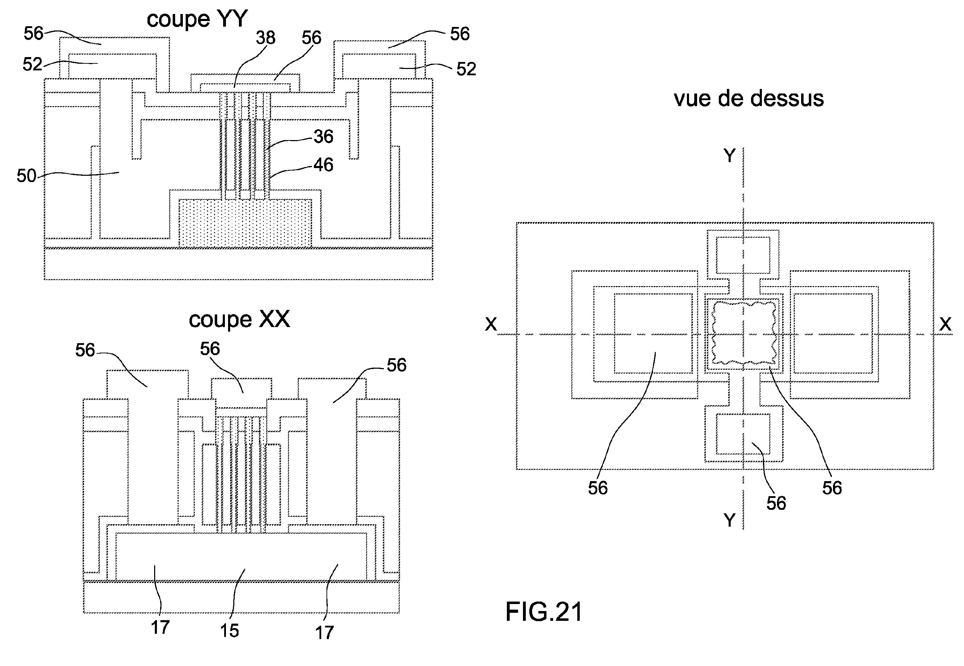

La dernière étape consiste à établir des interconnexions désirées permettant de relier la source, la grille et le drain du transistor vertical ainsi réalisé à d'autres éléments de circuit. Cette étape (éventuellement décomposée en sous-étapes) peut être exécutée par des procédés classiques en microélectronique. Sur la figure 21, on a représenté pour simplifier des interconnexions effectuées par un métal 56 déposé
- dans les ouvertures 54, en contact avec le drain 15
- au-dessus de la source 38,
- au-dessus des contacts de grille 52,
le métal déposé étant gravé selon un motif correspondant aux interconnexions désirées entre ce transistor et d'autres éléments de circuit.

La réalisation des interconnexions pourrait aussi impliquer des étapes plus complètes telles que le dépôt d'une couche isolante d'épaisseur plus importante que les couches existantes, l'ouverture de trous dans cette couche au-dessus des contacts de source 38, de drain 17 et de grille 52, le dépôt de métal dans les trous et en dehors des trous, et la gravure de ce métal selon le motif d'interconnexions désiré.

Dans une variante de réalisation de l'invention, on constitue une couche de grille sacrificielle 18 en oxyde de silicium et non en silicium polycristallin ou amorphe. Dans ce cas, les trous verticaux 32 sont directement creusés par faisceau d'électrons jusqu'à atteindre la surface de silicium de la région de drain, c'est-à-dire que si on se réfère à la figure 10, les trous 32 percent également la couche de nitrure 16;

Puis on fait croître par épitaxie le silicium peu dopé qui constitue les canaux semiconducteurs du transistor. Ces canaux ne sont pas entourés par une gaine isolante de faible épaisseur comme à la figure 13, mais ils sont noyés dans l'ensemble de la couche de grille sacrificielle 18 en oxyde de silicium.

Les étapes suivantes, expliquées en référence aux figures 14, 15 et 16, ne sont pas modifiées si ce n'est que les produits d'attaque de la couche de grille sacrificielle sont adaptées au fait que cette couche est en oxyde de silicium. Les canaux semiconducteurs entre source et grille sont alors constitués par des colonnes verticales de faible diamètre traversant une cavité laissée libre par l'enlèvement de la couche 18.

En faisant alors un dépôt isotrope d'isolant ou une oxydation thermique, on forme autour de chaque canal une gaine isolante semblable à la gaine 46 de la figure 17. Un espace reste libre entre les canaux adjacents ainsi gainés d'isolant. Cet espace sera ultérieurement rempli par la grille conductrice définitive. Un dépôt d'oxyde se forme aussi au-dessus de la source 38.

Les étapes suivantes sont inchangées.

Avec le procédé selon l'invention, on peut réaliser simultanément sur le même îlot de silicium deux transistors de type opposés, un NMOS et un PMOS, ayant leurs drains électriquement reliés et leurs grilles électriquement reliées, mais leurs sources séparées. Un tel assemblage sert à faire un inverseur à deux transistors complémentaires, ou inverseur CMOS.

Pour cela, on reprend le même principe de fabrication, mais on creuse les trous dans la grille sacrificielle en deux étapes : dans un premier temps on creuse des trous au-dessus d'une moitié seulement de la région de drain 15, et dans un deuxième temps on creuse des trous au-dessus de l'autre moitié de la région de drain. Les trous de la première moitié serviront à constituer les canaux du transistor NMOS et les trous de la deuxième moitié serviront à constituer les canaux du transistor PMOS (ou le contraire).

Après avoir creusé les trous de la première moitié, et avant de faire croître le silicium épitaxial dans ces trous, on fait une implantation ionique d'impuretés de type N (ou P) dans la première moitié de la région de drain à travers les trous qui les surplombent. Puis, apès l'étape expliquée en référence à la figure 14 (c'est-à-dire après croissance du silicium épitaxial des canaux et de la source et après recouvrement de la source 38 par un oxyde 40) on ouvre une deuxième série de trous, cette fois au-dessus de la deuxième moitié de la région de drain ; avant de faire croître le silicium épitaxial dans ces trous, on effectue une implantation ionique d'impuretés du type opposé P (ou N) dans la deuxième moitié de la région de drain, à travers les trous qui les surplombent. On refait, après croissance du silicium épitaxial des canaux et de la source du deuxième transistor, une étape semblable à celle de la figure 14, à savoir le dépôt d'une couche isolante qui recouvre la source du deuxième transistor. Enfin, on reprend les étapes expliquées aux figures 15 et suivantes pour éliminer la couche de grille sacrificielle, isoler les canaux par une gaine, et remettre une grille définitive dans la cavité laissée par la grille sacrificielle.

La grille sacrificielle pourrait également être en nitrure de silicium.

La grille définitive peut être en silicium polycristallin dopé ou en nitrure de titane, ou en alliage de silicium et tungstène ou en alliage de silicium et germanium.

L'invention permet de réaliser un transistor dont la longueur de canal est très bien contrôlée puisqu'elle est définie par l'épaisseur de la couche 18, dont le courant est très bien contrôlé car le canal est subdivisé en multiples canaux de faible diamètre entourés chacun d'une fine gaine isolante et individuellement enrobés par une grille de commande conductrice.

Dans l'invention, l'isolant de grille est déposé en fin de procédé technologique alors que les régions de source et de drain sont déjà définies ; il ne subit aucune gravure, ni nettoyage, ce qui garantit sa qualité ; il n'est pas pollué ni percé.

On notera que d'une manière générale, si l'îlot semiconducteur 12 est en silicium, les canaux seront en principe en silicium ; si l'îlot est en germanium, les canaux seront en principe en germanium. Cependant, on peut aussi envisager que l'îlot soit en silicium et les canaux en composé silicium-germanium, par exemple avec un alliage SiGe à 24% de germanium.

## Revendications

1. Procédé de fabrication d'un transistor à effet de champ vertical, comportant les étapes suivantes :
-a) délimitation d'un îlot de matériau semi-conducteur (12) formant une région de drain (15) latéralement adjacente à une région de contact de drain (17) ;
- b) dépôt d'au moins une couche (18) dite couche de grille sacrificielle, dont l'épaisseur définit la longueur des canaux séparant la région de drain d'une région de source (38) située au-dessus de la région de drain,
- c) perçage de plusieurs trous verticaux (32) dans la couche de grille sacrificielle, au dessus de la région de drain et jusqu'à la surface de matériau semi-conducteur de cette région,
- d) croissance épitaxiale de matériau semi-conducteur dans les trous à partir du matériau semi-conducteur de la région de drain, pour former à la fois des canaux semiconducteurs monocristallins verticaux (36) et la région de source (38) du transistor,
- e) dopage de la région de source,
- f) enlèvement de la couche de grille sacrificielle (18), laissant subsister les canaux (36) en matériau semi-conducteur entre la région de source et la région de drain, dans une cavité entourant ces canaux, et formation d'une gaine isolante (46) autour de chaque canal,
- g) remplissage de la cavité par un matériau conducteur (50) formant grille définitive isolée des canaux par les gaines isolantes,
- h) formation d'interconnexions (56) en contact avec la région de contact de drain (17), avec la région de source (38), et avec la grille définitive (50).

2. Procédé selon la revendication 1, **caractérisé en ce que** l'étape b comporte le dépôt d'une couche isolante (16), notamment du nitrure de silicium ou de l'oxyde de silicium ou du nitrure de germanium, avant le dépôt de la couche de grille sacrificielle (18), et le dépôt d'une couche isolante (20) après le dépôt de la couche de grille sacrificielle.

3. Procédé selon l'une des revendications 1, **caractérisé en ce que** la couche de grille sacrificielle (18) est gravée à l'étape b de manière à recouvrir la région de drain (15) et une région de contact de grille (22) extérieure à l'îlot de matériau semi-conducteur, mais pas la région de contact de drain (17).

4. Procédé selon l'une des revendications 1 à 3, **caractérisé en ce qu'**une étape de dépôt de couche isolante de planarisation (26) est effectuée après la gravure de la couche de grille sacrificielle (18), avant l'étape c.

5. Procédé selon l'une des revendications 1 à 4, **caractérisé en ce que** l'étape c comporte un perçage en utilisant une lithographie par faisceau d'électrons.

6. Procédé selon l'une des revendications 1 à 5, **caractérisé en ce que** le matériau de la grille définitive (50) est du silicium polycristallin dopé ou du nitrure de titane ou un alliage de silicium et tungstène ou un alliage de silicium et germanium.

7. Procédé selon l'une des revendications 1 à 6, **caractérisé en ce que** le matériau de la couche de grille sacrificielle (18) est du silicium polycristallin.

8. Procédé selon la revendication 7, **caractérisé en ce que** l'étape c de perçage de trous est suivie d'une étape d'oxydation du silicium de la grille sacrificielle à l'intérieur des trous avant l'étape d de croissance épitaxiale de silicium.

9. Procédé selon la revendication 8, **caractérisé en ce que** l'étape f d'enlèvement de la couche de grille sacrificielle (18) comprend l'enlèvement de l'oxyde formé après perçage des trous, puis le dépôt d'une très fine couche d'isolant, de préférence de l'oxyde de silicium, formant gaine isolante (46) individuelle autour de chaque canal.

10. Procédé selon l'une des revendications 1 à 6, **caractérisé en ce que** le matériau de la couche de grille sacrificielle est de l'oxyde de silicium ou du nitrure de silicium.

11. Procédé selon l'une des revendications 1 à 10, **caractérisé en ce que** l'on forme sur un même îlot de matériau semi-conducteur deux transistors de type opposé, NMOS et PMOS, ayant une région de drain commune, une grille commune, et des sources distinctes.

12. Transistor à effet de champ vertical **caractérisé en ce qu'**il comporte un îlot de matériau semiconducteur monocristallin dopé (12) comprenant une région de drain (15) et une région de contact de drain (17) disposée latéralement par rapport à la région de drain, et, au-dessus de l'îlot, une région de source (38) et plusieurs canaux parallèles verticaux (36) en matériau semiconducteur monocristallin peu dopé, s'étendant verticalement entre la région de drain et la région de source, chaque canal étant complètement entouré par une gaine isolante (46), et l'espace qui sépare les canaux ainsi isolés les uns des autres étant comblé par une grille conductrice (50) enrobant chacun des canaux.

13. Transistor à effet de champ vertical selon la revendication 12, **caractérisé en ce que** la grille (50) s'étend au-dessus de la région de drain (15) mais pas au-dessus de la région de contact de drain (17).

14. Transistor à effet de champ vertical selon la revendication 13, **caractérisé en ce que** la région de grille comporte au moins deux extensions (22) s'étendant latéralement en dehors des régions de drain et de contact de drain.
